# EUROPEAN PATENT SPECIFICATION

(11) **EP 3 081 839 B1**
(45) Date of publication and mention of the grant of the patent: **19.06.2019**
(21) Application number: 14868909.4
(22) Date of filing: 11.12.2014
(51) Int. Cl.: F16L 59/06, B32B 9/00, B32B 15/08, B32B 27/08, B32B 27/30, B32B 27/32

(54) **OUTER COVERING MATERIAL FOR VACUUM HEAT INSULATION MATERIALS, VACUUM HEAT INSULATION MATERIAL, AND HEAT INSULATION CONTAINER**
DECKSCHICHTMATERIAL FÜR VAKUUMWÄRMEDÄMMUNGSMATERIALIEN, VAKUUMWÄRMEDÄMMUNGSMATERIAL UND WÄRMEDÄMMUNGSBEHÄLTER
MATÉRIAU DE REVÊTEMENT EXTERNE POUR MATÉRIAUX D'ISOLATION THERMIQUE À VIDE, MATÉRIAU D'ISOLATION THERMIQUE À VIDE ET RÉCIPIENT D'ISOLATION THERMIQUE

(30) Priority: 11.12.2013 JP 2013255765
(43) Date of publication of application: 19.10.2016
(73) Proprietor: Toppan Printing Co., Ltd., Tokyo 110-0016 (JP)
(72) Inventor: OGAWARA, Kenji, Tokyo 110-0016 (JP); SATO, Tomoko, Tokyo 110-0016 (JP)
(74) Representative: TBK
(86) International application number: PCT/JP2014/082864
(87) International publication number: WO 2015/087976

(56) References cited:
- WO-A1-03/009998
- JP-A- 2004 130 654
- JP-A- 2006 266 348
- JP-A- 2007 056 922
- JP-A- 2008 008 400
- JP-A- 2008 110 604
- JP-A- 2011 143 693
- JP-A- 2012 219 956
- DATABASE WPI Week 200971 Thomson Scientific, London, GB; AN 2009-Q14602 XP002771845, & JP 2009 241328 A (NIPPON SYNTHETIC CHEM IND CO) 22 October 2009 (2009-10-22)

## Description

### TECHNICAL FIELD

The present invention relates to a packaging material for a vacuum insulator.

### BACKGROUND ART

Conventionally, a vacuum insulator having a structure in which a core enclosed by a packaging material is known.

In the vacuum insulator, the periphery of the core is in a vacuum state, the coefficient of thermal conductivity of a gas is extremely close to zero, and the heat insulation property is improved.

Therefore, it is necessary for such vacuum insulator to continuously hold the inside of a heat insulating material in vacuum in order to maintain the heat insulation property thereof for a long period of time.

In order to hold the vacuum degree of the inside of the vacuum insulator, in consideration of maintaining the heat insulation property of the vacuum insulator, it is of significant importance to improve the gas barrier property and the resistance to flexibility of the packaging material.

In a conventional lamination configuration of an exterior body having the vacuum insulator, a technique of using a metal foil or an aluminum-deposited polyethylene terephthalate film as a gas barrier layer is known (for example, refer to Patent Document 1).

Furthermore, as a specific packaging material using the aluminum-deposited polyethylene terephthalate film, a packaging material is disclosed in which a nylon film, two aluminum-deposited polyethylene terephthalate films, and a low density polyethylene are sequentially stacked in layers in order (for example, refer to Patent Document 2).

Moreover, JP 2009-241328 A discloses a multi-layer film having a layered constitution of a vapor deposition substrate film (A) formed by multi-stage vapor deposition and a gas barrier film (B). JP 2011-143693 A discloses a laminate for vacuum heat insulating material. JP 2007-056922 A discloses a vacuum heat insulating material wherein a core material is covered by an outer covering material. WO 03/009998 A1 discloses a deposition film comprising a base material substantially formed of a high molecular material and an deposition layer substantially formed of ceramic. JP 2008-008400 A discloses a vacuum heat insulating material which is configured by enclosing a heat insulating core material in both claddings and by evacuating the inside of the claddings. JP 2012-219956 A discloses a vacuum insulation material which includes: a core material comprised of a fiber material laminate; an outer packaging material which covers the core material by forming a metal deposited layer in at least one resin film of a plurality of resin films; and an adsorption material. JP 2004-130654 A discloses a vacuum heat insulating material wherein a heat insulating core material is encapsulated in the outer package made of a gas-barrier laminated film and the outer package is evacuated, and the laminated film includes a laminate in which a vapor-deposited thin film layer (A-layer), an intermediate coat layer (B-layer), which is formed by heating and drying a layer comprising a coating agent containing at least a water-soluble polymer and a vapor-deposited thin film layer (C-layer) are successively laminated on at least one surface of a substrate comprising a plastic material. JP 2008-110604 A discloses a multi-layered film comprising a gas-barrier film, a polyester type film, and a polyolefin type film.

### PRIOR ART DOCUMENTS

### PATENT DOCUMENTS

[Patent Document 1] Japanese Unexamined Patent Application, First Publication No. 2001-8828
[Patent Document 2] Japanese Unexamined Patent Application, First Publication No. 2010-138956

### SUMMARY OF INVENTION

### PROBLEMS TO BE SOLVED BY THE INVENTION

However, in the configuration using a metal foil as a gas barrier layer, a quantity of heat to be transmitted through the metal foil is large, and the heat insulation property of the vacuum insulator may not be sufficiently obtained.

Particularly, in the case of using an aluminum foil as a gas barrier film such as in a case of a conventional vacuum insulator, the thermal insulation effect of the vacuum insulator is reduced due to heat-transfer through the packaging material used in the vacuum insulator, which is referred to as a heat bridge phenomenon.

Even in the case of using a gas barrier film including a vapor-deposited film instead of a metal foil in order to prevent the heat bridge phenomenon, a sufficient heat insulation property has not been obtained.

Additionally, in the configuration using only an aluminum-deposited polyethylene terephthalate film as a gas barrier layer, the gas barrier property thereof is not sufficient, in some cases, the heat insulation property of the vacuum insulator is not sufficient.

Furthermore, in case of using a conventional packaging material, for example, applying a vacuum insulator to a cooling box or the like, when the cooling box in which contents are accommodated is transferred, the cooling box vibrates, and the contents may impact the surface of the cooling box due to this vibration.

In such case, there are problems in that pinholes are easily generated on the surface of the cooling box and a heat insulating function by vacuum may be deteriorated.

Consequently, the invention was made with respect to the above-described conventional art, and has an object to provide a packaging material for a vacuum insulator in which a quantity of heat to be transmitted through a gas barrier layer is low and which has a high degree of gas barrier property and provides excellent flex resistance.

Furthermore, the invention was made with respect to the above-described conventional art, and has an object to provide a packaging material for a vacuum insulator which provides excellent pinking resistance.

Additionally, the invention was made with respect to the above-described problems, and has an object to provide a packaging material for a vacuum insulator in which pinholes formed by impact due to vibration or the like is less likely to be generated, and an insulating container using the material.

### MEANS FOR SOLVING THE PROBLEMS

In order to solve the above-described problems, a packaging material for a vacuum insulator according to a first aspect of the invention is defined in claim 1 and includes: a barrier film
including a plastic base member; an aluminum-deposited ethylene-vinyl alcohol copolymer film stacked on the barrier film; and a heat-fusible layer stacked on the aluminum-deposited ethylene-vinyl alcohol copolymer film. A vapor-deposited thin film layer and a coating layer are sequentially stacked in layers in order on at least one surface of the plastic base member of the barrier film, wherein the vapor-deposited thin film layer is formed of a composite including: a metal or an inorganic oxide, or a metal and an inorganic oxide, wherein the coating layer is made of an aqueous solution or a coating agent, wherein the aqueous solution includes: a water-soluble polymer;
and at least one of (a) and (b), (a) being at least one of, one or more kinds of alkoxide, and one or more kinds of hydrolyzate of alkoxide, (b) being tin chlorides, and wherein the coating agent includes as a main agent a mixed solution of water and alcohol.

In the packaging material for a vacuum insulator according to the first aspect of the invention, the heat-fusible layer may be a linear low density polyethylene film.

In the packaging material for a vacuum insulator according to the first aspect of the invention, the plastic base member may be subjected to a plasma pretreatment by specific plasma using a hollow-anode plasma processing apparatus before the vapor-deposited thin film layer is vapor-deposited onto the plastic base member.

In the packaging material for a vacuum insulator according to the first aspect of the invention, the hollow-anode plasma processing apparatus may be a magnetic-assisted hollow-anode plasma processing apparatus further including a magnet.

In the packaging material for a vacuum insulator according to the first aspect of the invention, the plasma pretreatment may use at least one selected from the group consisting of argon, nitrogen, oxygen, and hydrogen and may use low-temperature plasma in which the self-bias value is 200V to 2000V and the Ed value defined by Ed=plasma density × processing time is 100 (V·s·m⁻²) to 10000 (V·s·m⁻²).

In the packaging material for a vacuum insulator according to the first aspect of the invention, the plasma pretreatment may include a first treatment step that is carried out using an inert gas; and a second treatment step that is subsequently carried out using at least one selected from the group consisting of nitrogen, oxygen, hydrogen, and a mixed gas thereof.

In the packaging material for a vacuum insulator according to the first aspect of the invention, the inert gas may be at least one of argon and helium.

In the packaging material for a vacuum insulator according to the first aspect of the invention, the plasma pretreatment may include: a first treatment step that is carried out using a mixed gas of nitrogen and oxygen; and a second treatment step that is subsequently carried out using hydrogen.

The packaging material for a vacuum insulator according to the first aspect of the invention may further include a nylon film provided between the barrier film and the aluminum-deposited ethylene-vinyl alcohol copolymer film.

The packaging material for a vacuum insulator according to the first aspect of the invention may further include: an oriented polypropylene film provided on a surface on the opposite side of the surface of the plastic base member on which the vapor-deposited thin film layer is formed.

A vacuum insulator according to a second aspect of the invention uses the packaging material according to the aforementioned first aspect.

An insulating container according to a third aspect of the invention uses the vacuum insulator according to the aforementioned second aspect.

A vacuum insulator according to a fourth aspect of the invention includes: an exterior body formed of a packaging material; and a core member enclosed inside the exterior body, wherein the inside of the exterior body is maintained in vacuum.

The packaging material forming the exterior body is formed of a laminate film in which a base material layer and a sealant layer are stacked.

The gas barrier property of the base material layer is higher than the gas barrier property of the sealant layer.

The surfaces of the sealant layers of two packaging materials are superimposed so as to face each other.

A seal portion at which the packaging materials are superimposed and sealed is provided at the peripheral edge portion of the packaging material, and the exterior body is sealed by the seal portion.

The end of the seal portion is surrounded by the base material layer so that the sealant layer is not exposed to the outside at the end of the seal portion.

In the vacuum insulator according to the fourth aspect of the invention, at the end of the seal portion at which the packaging materials are superimposed and sealed, one of the packaging material may be lengthened, the longer packaging material may be folded, and the seal portion may be formed so that the edge surfaces of the packaging material come into contact with each other.

In the vacuum insulator according to the fourth aspect of the invention, at the end of the seal portion, the packaging material may be obliquely cut so that the length of the upper side of the base material layer of the packaging material becomes larger and the length of the underside of the sealant layer of the packaging material becomes shorter.

In the vacuum insulator according to the fourth aspect of the invention, at the end of the seal portion at which the packaging materials are superimposed and sealed, each of the front-end portions of the packaging material may be folded back so as to be located inside the superimposed seal portions, and the seal portion may be formed so that the two packaging materials are superimposed in a state where the front-end portions are folded back.

In the vacuum insulator according to the fourth aspect of the invention, at the end of the seal portion at which the packaging materials are superimposed and sealed, the length of each base material layer of the packaging material may be larger than the length of the sealant layer, and the seal portion may be formed so that the longer base material layer is bent so as to cover the edge surface of the sealant layer.

In the vacuum insulator according to the fourth aspect of the invention, at the end of the seal portion at which the packaging materials are superimposed and sealed, at one of the packaging materials, the length of the base material layer may be larger than the length of the sealant layer, and the seal portion may be formed so that the longer base material layer is bent so as to cover both edge surfaces of the sealant layers of the two packaging materials.

In the vacuum insulator according to the fourth aspect of the invention, at the end of the seal portion at which the packaging materials are superimposed and sealed, the length of the base material layer of each packaging material may be larger than the length of the sealant layer, and the seal portion may be formed so that the front-end portion of the longer base material layer covers both the edge surfaces of the sealant layer and is folded back to be located inside the superimposed seal portions.

### Effects of the Invention

According to the packaging material of the first aspect of the invention, the effect is obtained that it is possible to provide the packaging material for a vacuum insulator in which a quantity of heat to be transmitted through the gas barrier layer is low and which has a high degree of gas barrier property and provides excellent flex resistance.

For this reason, according to the vacuum insulator of the second aspect of the invention and the insulating container of the third aspect, it is possible to maintain a high degree of vacuum state even in use for a long time; furthermore, since a quantity of heat to be transmitted through the gas barrier layer is low, the effect is obtained that the heat insulation property can be maintained.

According to of the vacuum insulator of the fourth aspect of the invention, the sealant layer of the packaging material which forms an exterior body is surrounded by the base material layer so as not to be exposed to the outside, it is possible to prevent gas such as air from being transmitted from the outside of the vacuum insulator to the inside thereof, and it is possible to maintain the heat insulation property for a long time.

### BRIEF DESCRIPTION OF THE DRAWINGS

FIG. 1 is a cross-sectional view showing a vacuum insulator.
FIG. 2 is a cross-sectional view showing a vacuum insulator packaging material according to the first embodiment of the invention.
FIG. 3 is a schematic view showing the configuration of an example of a hollow-anode plasma processing apparatus used in the first embodiment of the invention.
FIG. 4 is a schematic view showing the configuration of an example of a magnetic-assisted hollow-anode plasma processing apparatus which is preferably used in the first embodiment of the invention.
FIG. 5 is a cross-sectional view showing the configuration in which a coating layer, a vapor-deposited thin film layer, and a base member are further provided on a base member of the vacuum insulator packaging material according to the first embodiment of the invention.
FIG. 6 is a cross-sectional view showing a vacuum insulator packaging material of Example A1.
FIG. 7 is a cross-sectional view showing a vacuum insulator packaging material of the Comparative Example A1.
FIG. 8 is a cross-sectional view showing a vacuum insulator packaging material of the Comparative Example A2.
FIG. 9 is a cross-sectional view partially showing a vacuum insulator according to a fifth embodiment of the invention.
FIG. 10 is a cross-sectional view partially showing the vacuum insulator packaging material according to the fifth embodiment of the invention.
FIG. 11 is an explanatory diagram schematically showing a vacuum insulator according to a sixth embodiment of the invention in cross section.
FIG. 12A is an enlarged explanatory cross-sectional view showing the end of a seal portion of the vacuum insulator according to the sixth embodiment of the invention.
FIG. 12B is an enlarged explanatory cross-sectional view showing the end of the seal portion of the vacuum insulator according to the sixth embodiment of the invention.
FIG. 13A is an enlarged explanatory cross-sectional view showing a modified example of the configuration the end of the seal portion of the vacuum insulator according to the sixth embodiment of the invention.
FIG. 13B is an enlarged explanatory cross-sectional view showing a modified example of the configuration the end of the seal portion of the vacuum insulator according to the sixth embodiment of the invention.
FIG. 14A is an enlarged explanatory cross-sectional view showing the end of a seal portion of the vacuum insulator according to a seventh embodiment of the invention.
FIG. 14B is an enlarged explanatory cross-sectional view showing the end of a seal portion of the vacuum insulator according to the seventh embodiment of the invention.
FIG. 15A is an enlarged explanatory cross-sectional view showing the end of a seal portion of the vacuum insulator according to an eighth embodiment of the invention.
FIG. 15B is an enlarged explanatory cross-sectional view showing the end of a seal portion of the vacuum insulator according to the eighth embodiment of the invention.
FIG. 16A is an enlarged explanatory cross-sectional view showing the end of a seal portion of the vacuum insulator according to a ninth embodiment of the invention.
FIG. 16B is an enlarged explanatory cross-sectional view showing the end of a seal portion of the vacuum insulator according to the ninth embodiment of the invention.
FIG. 17 is an enlarged explanatory cross-sectional view showing a modified example of the configuration the end of the seal portion of the vacuum insulator according to the ninth embodiment of the invention.
FIG. 18A is an enlarged explanatory cross-sectional view showing the end of a seal portion of the vacuum insulator according to a tenth embodiment of the invention.
FIG. 18B is an enlarged explanatory cross-sectional view showing the end of a seal portion of the vacuum insulator according to the tenth embodiment of the invention.

### EMBODIMENTS FOR CARRYING OUT THE INVENTION

Hereinafter, embodiments of the invention will be described with reference to drawings.

In each drawing described below, in order for the respective components to be of understandable size in the drawings, the dimensions and the proportions of the components are modified as needed compared with the real components.

### First Embodiment

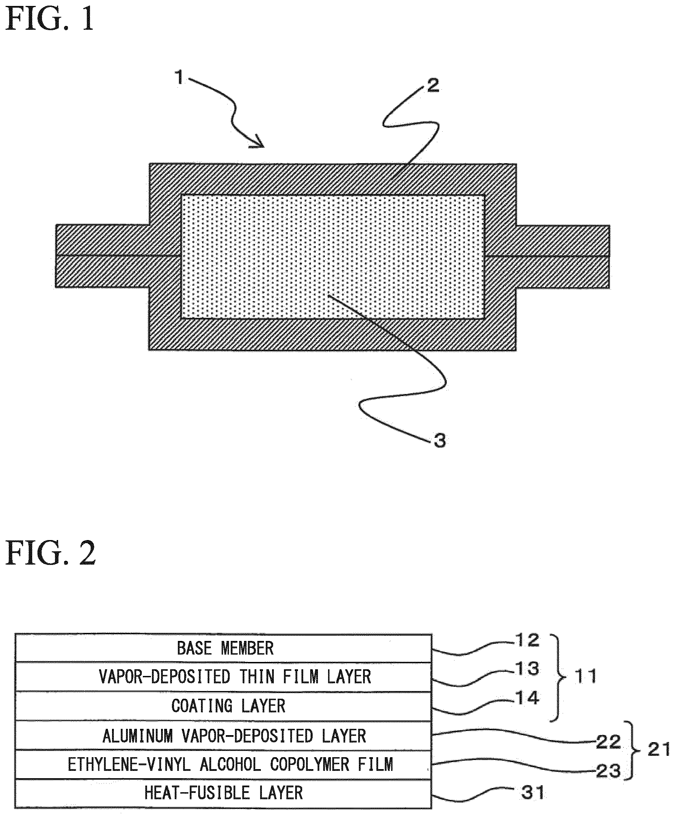

FIG. 1 is a cross-sectional view showing a vacuum insulator using a packaging material according to a first embodiment of the invention.

A vacuum insulator 1 includes a core 3 and a packaging material 2 formed so as to cover the core 3.

In the vacuum insulator 1, the circumference of the core 3 which is surrounded by the packaging material 2 is deaerated, and the inside of the vacuum insulator 1 is maintained in a vacuum state.

As shown in FIG. 2, the vacuum insulator packaging material according to a first embodiment of the invention is a layered body in which a barrier film 11, an aluminum-deposited ethylene-vinyl alcohol copolymer film 21, and a heat-fusible layer 31 are sequentially stacked in layers in order.

Here, the barrier film 11 has the configuration in which a base member 12 (plastic base member) formed of a plastic film, a vapor-deposited thin film layer 13, and a coating layer 14 (first coating layer) which are sequentially stacked in layers in order as shown in FIG. 2.

Particularly, the vapor-deposited thin film layer 13 is formed on the base member 12 by vapor deposition of a metal, inorganic oxide, or a composite including a metal or inorganic oxide on at least one surface of the base member 12 (at least one of surfaces).

The coating layer 14 is formed of an aqueous solution or a coating agent, the aqueous solution includes: a water-soluble polymer; and at least one of (a) and (b), (a) is at least one of, one or more kinds of alkoxide, and hydrolyzate of alkoxide, (b) is tin chlorides, and the coating agent includes as a main agent a mixed solution of water and alcohol.

The vapor-deposited thin film layer 13 and the coating layer 14 function as a first layer forming a gas barrier layer and a second layer, respectively.

Firstly, the base member 12 will be described.

As a material used to form the base member 12, for example, a polyester film such as polyethylene terephthalate (PET) or polyethylene naphthalate (PEN), a polyolefin film such as polyethylene or polypropylene, a polystyrene film, a polyamide film, a polycarbonate film, a polyacrylonitrile film, a polyimide film, or the like can be used.

As long as the base member 12 is formed of a material having a mechanical strength or a dimensional stability, an oriented material or an unoriented material may be adopted.

Particularly, in consideration of heat resistance, a polyethylene terephthalate film which is biaxially-oriented in two axial directions or a nylon film is preferably used.

Furthermore, well-known various addition agents or stabilizers, for example, an antistatic agent, a ultraviolet protectant, a plasticizer, a lubricant, or the like may be used on the surface on which the vapor-deposited thin film layer 13 is to be provided and which is on the opposite side of the surface of the base member 12.

Additionally, in order to improve the adhesion between the base member 12 and the vapor-deposited thin film layer 13, any of treatment such as corona treatment, low-temperature plasma treatment, ion bombardment treatment, chemical treatment, solvent treatment, or the like may be carried out on the base member 12 as a pretreatment before the vapor-deposited thin film layer 13 is vapor-deposited onto the base member 12.

Here, as an example of pretreatment which is carried out on the base member 12 before the vapor-deposited thin film layer 13 is vapor-deposited thereon in order to improve the adhesion between the base member 12 and the vapor-deposited thin film layer 13, plasma pretreatment by specific plasma using a hollow-anode plasma processing apparatus will be described.

The hollow-anode plasma processing apparatus is provided in, for example, a vacuum chamber.

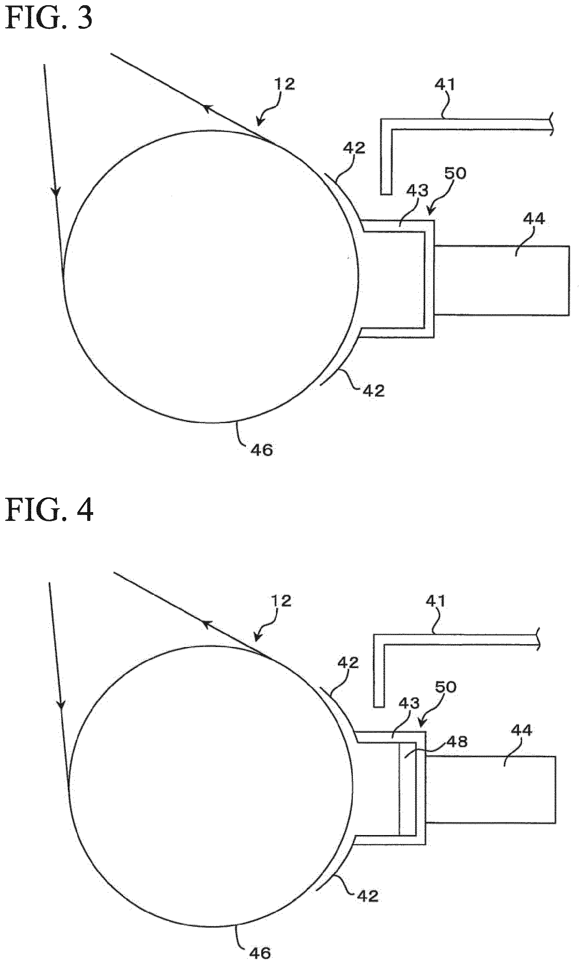

As shown in FIG. 3, the hollow-anode plasma processing apparatus includes: a matching box 44 that is used to match impedance; a hollow box-shaped electrode 43 connected to the matching box 44; a shield plate 42 provided so as to expand from the end of the electrode 43; an introducer 41 that is used to introduce a plasma gas thereinto, a processing chamber 50, and a cooling drum 46 that is provided so as to the electrode 43 and supports the base member 12.

The matching box 44 is electrically connected to the shield plate 42 with the electrode 43 interposed therebetween.

Moreover, the matching box 44 is also electrically connected to the introducer 41.

In the hollow-anode plasma processing apparatus, the electrode 43 is used as an anode, the surface area (Sa) of the anode and the surface area (Sc) of the substrate which is located at the counter electrode satisfy the relationship of Sa>Sc.

As the surface area of hollow box-shaped electrode increases, it is possible to generate a large self bias on a cathode which is serves as a counter electrode, that is, on the base member 12.

As a result of the generation of the large self bias, the base member 12 can be subjected to plasma treatment with a high ion density, and it is possible to realize stable and powerful plasma surface treatment with a high-speed.

As shown in FIG. 4, it is preferable that the hollow-anode plasma processing apparatus be a magnetic-assisted hollow-anode plasma processing apparatus in which a magnet 48 such as a permanent magnet or an electromagnet is further provided at the bottom of the electrode 43.

As a result of providing the magnet 48 at the bottom of the electrode 43, the plasma generated near the electrode is confined in the box-shaped electrode 43 by the action of the magnet, and it is possible to generate a larger self bias on a cathode which is serves as a counter electrode, that is, on the base member 12.

As a result of the generation of the large self bias as described above, the base member 12 can be subjected to plasma treatment with a high ion density, and it is possible to realize further stable and further powerful plasma surface treatment with a high-speed.

In the plasma pretreatment by specific plasma using a hollow-anode plasma processing apparatus, it is preferable that at least one selected from the group consisting of argon, nitrogen, oxygen, and hydrogen be used as a plasma gas, and that a low-temperature plasma treatment be used in which the self-bias value on the base member 12 is 200V to 2000V and the Ed value defined by Ed=plasma density × processing time is 100 V·s·m⁻² to 10000 V·s·m⁻².

In the case where the Ed value is less than 100 V·s·m⁻², the adhesion tends to be insufficient.

Moreover, in the case where it exceeds 10000 V·s·m⁻², the treatment is excessive, and the superficial layer tends to be brittle.

Furthermore, as the plasma pretreatment by specific plasma using a hollow-anode plasma processing apparatus, it is possible to use: a first treatment step that is carried out using an inert gas; and a second treatment step that is continuously carried out using at least one gas selected from nitrogen, oxygen, hydrogen, and a mixed gas thereof.

As the inert gas, at least one selected from the group consisting of argon and helium can be used.

Alternatively, as the plasma pretreatment, it is possible to use: a first treatment step that is carried out using a mixed gas of nitrogen and oxygen; and a second treatment step that is continuously carried out using hydrogen.

The thickness of the base member 12 is not particularly limited.

Furthermore, in consideration of suitability of the base member 12 used in the packaging material 2, a film can be used in which films having different characteristics are stacked in layers and which is other than the film formed of a simple body.

In consideration of workability, the thickness of the base member 12 is preferably in the range of 3 to 200 µm, and 6 to 30 µm is particularly preferable.

Furthermore, in consideration of mass productivity, it is preferable that the base member 12 be made of a continuous film having a long length, and that each layer of the film can be continuously formed.

Next, the vapor-deposited thin film layer 13 will be described.

The vapor-deposited thin film layer 13 is a vapor-deposited film made of a metal such as aluminum, copper, silver, an inorganic oxide such yttrium-tantalum oxide, aluminum oxide, silicon oxide, magnesium oxide, or a composite including the aforementioned material, and has the gas barrier property against oxygen, moisture vapor, or the like.

From the aforementioned materials, particularly, aluminum, aluminum oxide, silicon oxide, and magnesium oxide are preferably used.

In other cases, it is not limited to the above-mentioned metal and inorganic oxide; as long as a material having the gas barrier property against oxygen, moisture vapor, or the like, the material can be used.

Regarding the thickness of the vapor-deposited thin film layer 13, the optimum condition thereof varies depending on the kinds of material to be used or the configuration thereof. The thickness is preferably within the range of 5 to 300 nm and the thickness can be suitably selected.

In the case where the film thickness is less than 5 nm, a uniform film cannot be obtained, and the film thickness is not sufficient.

Moreover, in the case of inorganic oxide, in the case where the film thickness exceeds 300 nm, it is not possible to provide flexibility, there is a concern that a thin film is cracked due to external factors such as folding or pulling after the film is formed.

The range of 10 to 150 nm is preferable.

As a formation method, by using a general vacuum deposition method, the vapor-deposited thin film layer 13 can be formed on the base member 12 (plastic film base member).

Furthermore, as other methods of forming a thin film, a sputtering method, an ion plating method, a plasma vapor deposition method (PCVD), or the like can also be used.

In consideration of productivity, a vacuum deposition method is most excellent at the moment.

As a heating method in the vacuum deposition method, any of an electron beam heating method, a resistance heating method, an induction heating method is preferably used.

Moreover, vapor deposition can also be carried out by use of a plasma-assisted method or an ion beam assisted method in order to improve the adhesion between the vapor-deposited thin film layer 13 and the base member 12 and the denseness of the vapor-deposited thin film layer 13.

In addition, reactive vapor deposition with blow of oxygen gas or the like may be carried out during vapor deposition in order to improve the transparency of the vapor-deposited thin film layer 13.

Next, the coating layer 14 will be described.

The coating layer 14 is formed by use of an aqueous solution or a coating agent, the aqueous solution includes: a water-soluble polymer; and at least one of (a) and (b), (a) is one or more kinds of alkoxide and/or one or more kinds of hydrolyzate of alkoxide (in other words, at least one of "one or more kinds of alkoxide" and "one or more kinds of hydrolyzate of alkoxide"), (b) is tin chlorides, and the coating agent includes as a main agent a mixed solution of water and alcohol.

For example, by preparing a solution in which a water-soluble polymer and tin chloride are dissolved by a water solvent (water or, a mixture of water and alcohol) or by preparing a solution in which metal alkoxide is directly mixed thereinto or a material that is previously subjected to a processing such as hydrolysis is mixed thereinto, a coating agent is obtained.

After the vapor-deposited thin film layer 13 made of inorganic oxide is coated with the coating agent, the coating agent is subjected to heating and drying, and thereby the coating layer 14 is formed.

As a water-soluble polymer used in a coating agent, polyvinyl alcohol, polyvinylpyrrolidone, starch, methylcellulose, carboxymethyl cellulose, sodium alginate, or the like is adopted.

Particularly, the gas barrier property is most excellent by use of polyvinyl alcohol (PVA).

Generally, the PVA is obtained by saponifying polyvinyl acetate.

As the PVA, so-called partially saponified PVA in which several tens of percent of an acetic acid group remain in the PVA may be used, or completely saponified PVA or the like in which only several percent of an acetic acid group remain in the PVA may be used.

The specific configuration of PVA is not particularly limited.

Additionally, tin chloride used in the coating agent may be stannous chloride (SnCl₂), stannic chloride (SnCl₄), or a composite of stannous chloride and stannic chloride.

Moreover, the aforementioned tin chloride may be anhydride or hydrate.

Furthermore, the metal alkoxide used in the coating agent is a compound expressed by the general expression M (OR)n (the M is a metal such as Si, Ti, Al, Zr, the R is a alkyl group such as CH3, C₂H₅, and the n is positive integer).

Specifically, tetraethoxysilane Si (OC₂H₃)₄, triisopropoxy aluminum Al (O-2'-C₃H₇)₃, or the like is adopted, particularly, tetraethoxysilane and triisopropoxy aluminum are relatively stable in a water solvent after hydrolysis and are thereby preferably used.

As long as the coating agent does not fail the gas barrier property, a isocyanate compound, a silane coupling agent, or a known additive such as a dispersant, a stabilizer, a viscosity modifier, a colorant can be added to the coating agent as appropriate.

For example, as an isocyanate compound that is to be added to the coating agent, it is preferable to use the compound having two or more isocyanate groups in the molecule which forms the compound.

For example, monomers such as tolylenediisocyanate, triphenylmethane triisocyanate, tetramethylxylene diisocyanate, a polymer including the aforementioned compound, or a derivative are adopted.

As an application method of the coating agent, a conventionally-known method such as a generally-used dipping method, a roll coating method, a screen printing method, a spraying method, a gravure printing method can be used.

The thickness of the coating varies with the kinds of coating agent, a processing machine, or machining conditions.

In the case where the thickness of the post-dried coating is less than or equal to 0.01 µm, a uniform coating film cannot be obtained, the sufficient gas barrier property cannot be obtained in some cases, and it is not preferable.

In addition, in the case where the thickness of the coating exceeds 50 µm, there is a problem in that a crack is likely to occur.

The range of 0.01 to 50 µm is preferable, and the range of 0.1 to 10 µm is more preferable.

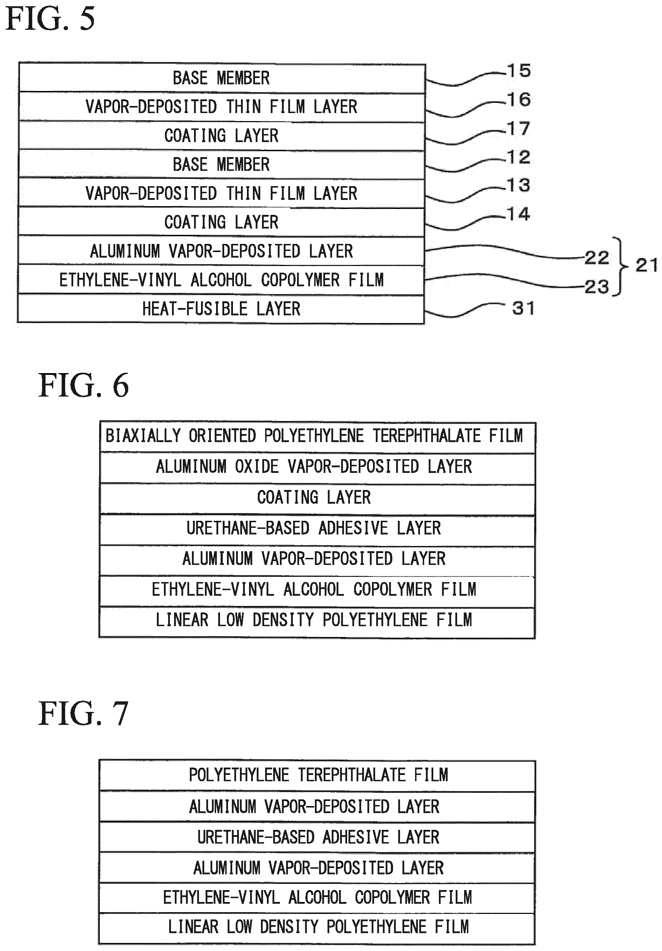

In other cases, as shown in FIG. 5, a coating layer 17 (second coating layer), a vapor-deposited thin film layer 16 (second vapor-deposited thin film layer), and a base member 15 (second base member) can be further formed on the base member 12 (surface of the base member 12 (first base member) on the opposite side of the surface on which the vapor-deposited thin film layer 13 (first vapor-deposited thin film layer) is to be formed in the similar manner, and a plurality of layers can be provided as appropriate.

Next, the aluminum-deposited ethylene-vinyl alcohol copolymer film 21 will be described.

As shown in FIG. 2, the aluminum-deposited ethylene-vinyl alcohol copolymer film 21 has the structure in which aluminum is vapor-deposited onto at least one surface of an ethylene-vinyl alcohol copolymer film 23 and an aluminum vapor-deposited layer 22 is thereby formed.

The thickness of the aluminum-deposited ethylene-vinyl alcohol copolymer film is not particularly determined, but approximately 12 to 15 µm is more preferable.

Next, the heat-fusible layer 31 will be described.

The heat-fusible layer 31 is referred to as a sealant layer, polyethylene, unoriented polypropylene, polyacrylonitrile, unoriented polyethylene terephthalate, unoriented nylon, or the like can be used as the heat-fusible layer.

In the case where a linear low density polyethylene film is used as the heat-fusible layer 31, degrees of pinking resistance and flex resistance are high, the sealability is excellent, and therefore it is particularly appropriate for the heat-fusible layer.

Finally, as a method of stacking various layers which form the vacuum insulator packaging material according to a first embodiment of the invention, a dry lamination method using a two-liquid curable urethane-based adhesive, an extrusion lamination method, or the like is adopted; however, the stacking method is not particularly limited.

Next, second to fourth embodiments of the invention will be described.

In the second to fourth embodiments, identical reference numerals are used for the elements which are identical to those of the first embodiment, and the explanations thereof are omitted or simplified here.

### Second Embodiment

In a vacuum insulator packaging material according to a second embodiment of the invention, an oriented nylon film (nylon film) is provided between the barrier film 11 and the aluminum-deposited ethylene-vinyl alcohol copolymer film 21.

According to this configuration, not only the effect described in the above first embodiment but also high degrees of pinking resistance and flex resistance are obtained.

### Third Embodiment

In a vacuum insulator packaging material according to a third embodiment of the invention, an oriented polypropylene film (OPP) is provided on the surface on the opposite side of the surface of the base member 12 on which the vapor-deposited thin film layer 13 is formed.

In other words, the oriented polypropylene film is provided on the uppermost layer of the packaging material 2, that is, over the entire periphery of the outer layer of the plastic base member.

According to this configuration, not only the effect described in the above first embodiment but also high degrees of pinking resistance and flex resistance are obtained.

Furthermore, it is preferable that a polyamide film be provided between the oriented polypropylene film and the base member 12.

Even in this case, it is possible to further improve the pinking resistance.

### Fourth Embodiment

In a vacuum insulator packaging material according to a fourth embodiment of the invention, an oriented nylon film is provided between the barrier film 11 and the aluminum-deposited ethylene-vinyl alcohol copolymer film 21, and furthermore an oriented polypropylene film is provided on the surface on the opposite side of the surface of the base member 12 on which the vapor-deposited thin film layer 13 is formed.

According to this configuration, not only the effect described in the above first embodiment but also high degrees of pinking resistance and flex resistance are obtained.

### Fifth Embodiment

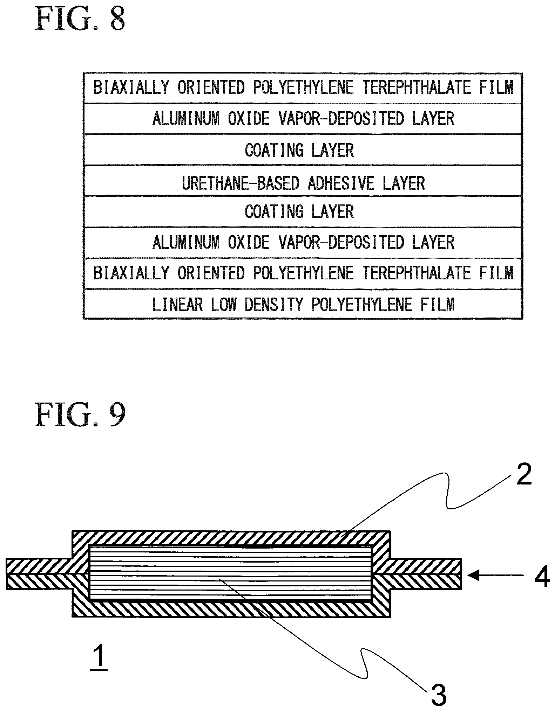

FIG. 9 is a cross-sectional view partially showing a vacuum insulator according to the fifth embodiment of the invention.

The vacuum insulator 1 has the structure in which the core 3 is enclosed by (sandwiched between) two packaging materials 2.

The two packaging materials 2 are adhered by a seal portion 4 and the inside of the vacuum insulator 1 in which the core 3 is disposed is maintained in vacuum.

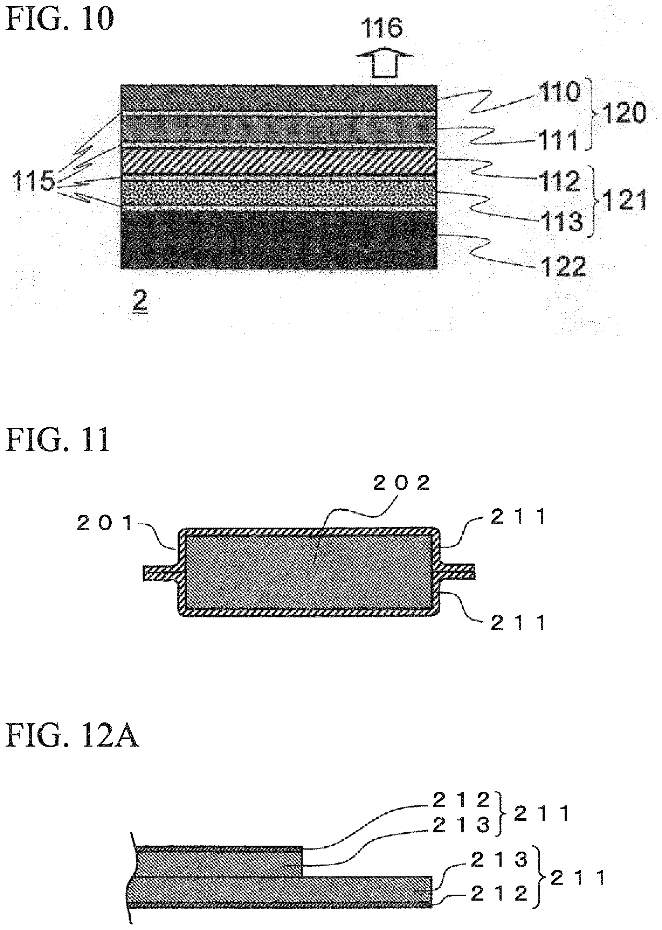

FIG. 10 is a cross-sectional view partially showing the packaging material 2 that forms a vacuum insulator according to the fifth embodiment of the invention.

### Base Material Layer

As a base material layer 120, an oriented polypropylene film 110 is used.

It is preferable that the base material layer 120 be formed of two layers of the oriented polypropylene film 110 and an oriented nylon film 111.

In the case where an oriented nylon film is used as the base material layer 120, the strength of the vacuum insulator packaging material increases.

### Barrier Layer

A barrier layer 121 is formed of two layers of an aluminum-deposited polyethylene terephthalate film 112 and an aluminum-deposited ethylene-vinyl alcohol copolymer film 113.

As a result of using a gas barrier film having a vapor-deposited film as the barrier layer 121 without using a metal foil, heat bridge phenomenon is resolved.

In order to complement a gap or a defect which occurs in the deposit on the deposition surface, it is preferable to stack the aluminum-deposited polyethylene terephthalate film 112 and the aluminum-deposited ethylene-vinyl alcohol copolymer film 113 so that the deposition surfaces of the gas barrier films face each other.

Each of the thickness of the aluminum-deposited polyethylene terephthalate film 112 and the thickness of the aluminum-deposited ethylene-vinyl alcohol copolymer film 113 is preferably 9 to 25 mm.

### Sealant Layer

A sealant layer 122 is formed of a linear low density polyethylene film having a density of 0.935 g/cm³ or less.

The thickness of the sealant layer 122 is preferably 30 to 80 mm.

In the case where the density of the linear low density polyethylene film is high such as 0.94 g/cm³, the flex resistance thereof is degraded, and it is not preferable.

The layers adjacent to each other which form the vacuum insulator packaging material of the invention are attached with an adhesive layer 115 interposed therebetween.

As the adhesive layer 115, for example, a two-liquid curable urethane-based adhesive can be used.

As a method of stacking a plurality of layers which form the vacuum insulator packaging material, a dry lamination method, an extrusion lamination method, or the like can be adopted.

Particularly, the packaging material 2 which is obtained in the above-described manner is used so that the base material layer 120 is located at the outer side 116 of the vacuum insulator 1.

Next, sixth to tenth embodiments of the invention will be described.

In the embodiments which will be described below, vacuum insulators have a core member (core) enclosed in an exterior body, and the inside of the exterior body is maintained in a vacuum state; and the embodiments provide vacuum insulators which improve the gas barrier property of the exterior body, prevent a gas such as air from being transmitted thereinto from the outside, and can maintain the heat insulation property for a long time.

### Sixth Embodiment

FIG. 11 is an explanatory diagram schematically showing a vacuum insulator according to a sixth embodiment of the invention in cross section.

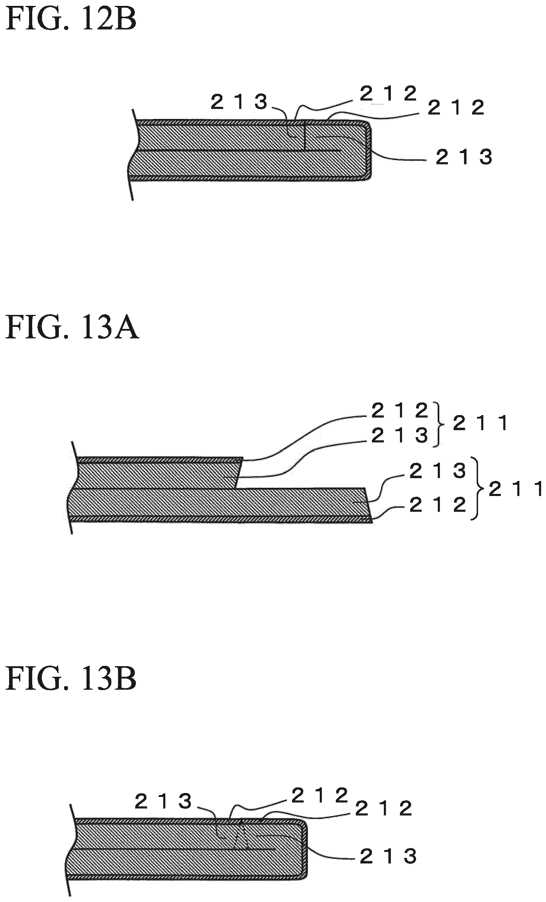

FIGS. 12A and 12B are enlarged explanatory cross-sectional views showing the end of a seal portion of the vacuum insulator according to the sixth embodiment of the invention.

FIGS. 13A and 13B are enlarged explanatory cross-sectional views showing a modified example of the configuration the end of the seal portion of the vacuum insulator according to the sixth embodiment of the invention.

In the vacuum insulator according to the sixth embodiment, a packaging material 211 forming an exterior body 201 is formed of a laminate film in which a base material layer 212 and a sealant layer 213 having the gas barrier property lower than that of the base material layer 212.

The peripheral edge portions of the two packaging materials 211 are sealed by superimposing the sealant layers 213 which form two packaging materials 211 so as to face each other, and the exterior body 201 is thereby formed.

As shown in FIG. 11, a core member 202 is enclosed inside the exterior body 201.

The inside of the exterior body 201 is maintained in a vacuum state, the exterior body 201 is tightly sealed by heat-sealing the peripheral edge portions of the two packaging materials 211, and the vacuum insulator is thereby formed.

As a material used to form the base material layer 212 of the packaging material 211, materials are preferably used which have high degrees of heat resistance and gas barrier property.

The base material layer 212 may be formed of not only a single layer but also a multilayer.

As a material having a high degree of gas barrier property, an aluminum foil; a deposited film in which a metal such as aluminum or inorganic oxide such as silicon oxide or aluminum oxide is vapor-deposited onto a vapor-deposition base film such as polyester, nylon, ethylene vinyl alcohol copolymer; a resin having a high degree of barrier property such as an ethylene-vinyl alcohol copolymer resin; or a film made of a so-called MXD nylon made of polyvinyl alcohol or metaxylene diamine/adipic acid is preferably used.

Moreover, a biaxially-oriented film made of polyester such as polyethylene terephthalate having a relatively high gas barrier property and providing heat resistance, a biaxially-oriented film made of nylon such as 6 nylon, or a biaxially-oriented film made of polypropylene is also used as the base material layer 212, and a multi-layer film in which the above-mentioned materials are combined and layered is used as the base material layer 212.

As the sealant layer 213, a hot-melt resin having a high degree of sealability is used.

A cast film such as polypropylene, low density polyethylene, linear low density polyethylene, or acid-modified polyethylene is used as the sealant layer 213.

Consequently, the base material layer 212 is formed using a material having a high degree of gas barrier property, and the gas barrier property of the base material layer 212 is higher than that of the sealant layer 213.

Attachment between the base material layer 212 of the packaging material 211 and the sealant layer 213 may be carried out by dry lamination with an adhesive interposed therebetween or may be carried out by sandwich lamination with a molten resin interposed therebetween.

Additionally, extrusion lamination may be carried out by melting and extruding the resin of the sealant layer 213.

Moreover, in the case where the base material layer 212 has a multilayer, attachment between the layers adjacent to each other may be carried out by dry lamination with an adhesive interposed therebetween or may be carried out by sandwich lamination with a molten resin interposed therebetween.

As a material used to form the core member 202, glass wool, silica, or the like is preferably used.

In this case, the internal space can easily be in a vacuum state.

In the vacuum insulator according to the sixth embodiment, the length of one of the packaging materials 211 (first packaging material) is longer than the length of the other of the packaging materials 211 (second packaging material) in advance.

Because of this, the end of one of the packaging materials 211 protrudes from the end of the other of the packaging materials 211 at the end of the seal portion at which the two packaging materials 211 are superimposed and sealed shown in FIG. 12A.

As shown in FIG. 12B, the seal portion is formed by folding the longer packaging material 211 so that the end faces of the packaging material 211 come into contact with each other.

The folded portion may be formed by being hot-melted in advance before the peripheral edge portion is sealed.

As a result of forming the seal portion as stated above, at the end of the seal portion at which the packaging materials 211 are superimposed and sealed, the sealant layer 213 is not exposed to the outside, and the sealant layer 213 is surrounded by the base material layer 212.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

Regarding each of the ends of the two packaging materials 211 which are superimposed at the seal portion, as shown in FIG. 13A, the packaging material 211 can be obliquely cut in advance so that the upper side of the base material layer 212 of the packaging material 211 becomes longer and the underside of the sealant layer 213 of the packaging material 211 becomes shorter.

In the case where the end of the packaging material 211 is formed as mentioned above, the seal portion is formed so that the longer packaging material 211 is folded and the upper sides of the base material layers 212 of the two packaging materials 211 are in contact with each other, or so that the front-end portions of the base material layers 212 overlap each other.

In this case, the hot-melt resin forming the sealant layer 213 is melted, the melted hot-melt resin flows into the space which is formed on the edge surface having an oblique shape, and the spaced is filled with the hot-melt resin.

According to the above-described method, during sealing, the melted hot-melt resin of the sealant layer 213 does not pass through between the base material layers 212 and does not protrude to the outer side of the packaging material 211.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

### Seventh Embodiment

Hereinbelow, a seventh embodiment of the invention will be described.

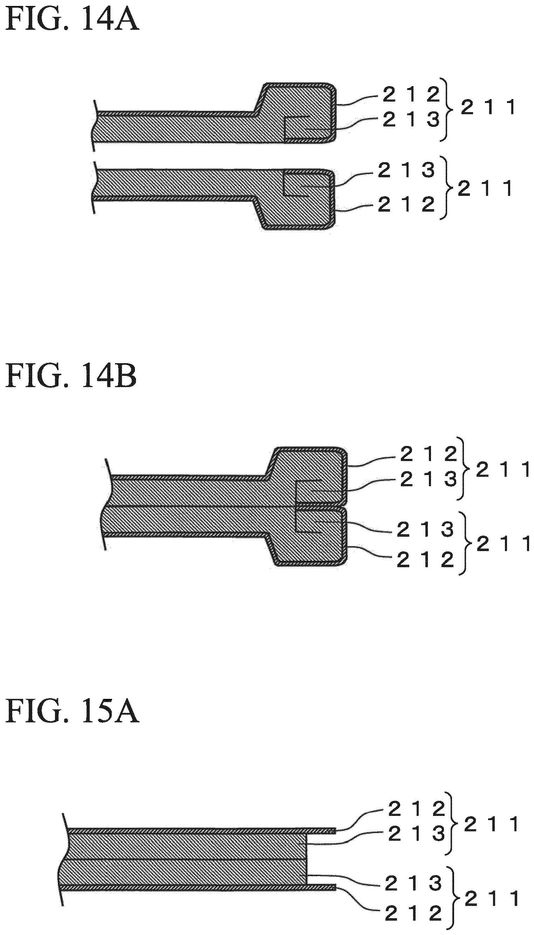

FIGS. 14A and 14B are enlarged explanatory cross-sectional views showing the end of a seal portion of the vacuum insulator according to a seventh embodiment of the invention.

A vacuum insulator according to the seventh embodiment is formed in the substantially same shape and of the same material as that of the vacuum insulator according to the sixth embodiment.

Moreover, the vacuum insulator according to the seventh embodiment is different from the vacuum insulator according to the sixth embodiment in configuration of the end of the seal portion at which the two packaging materials 211 are superimposed and sealed.

In the vacuum insulator according to the seventh embodiment, as shown in FIG. 14A, the front-end portion of the packaging material 211 is folded back so as to be located inside the superimposed seal portions at the end of the seal portion at which the two packaging materials 211 are superimposed and sealed.

Furthermore, as shown in FIG. 14B, two packaging materials 211 are superimposed in a state where each front-end portion is folded back.

As a result of forming the seal portion in the above-described manner, at the ends of the seal portions which are superimposed and sealed, the base material layers 212 of the two packaging materials 211 are brought into close contact with each other and are surrounded by the base material layer 212, and the sealant layers 213 are not exposed to the outside.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

### Eighth Embodiment

Hereinbelow, an eighth embodiment of the invention will be described.

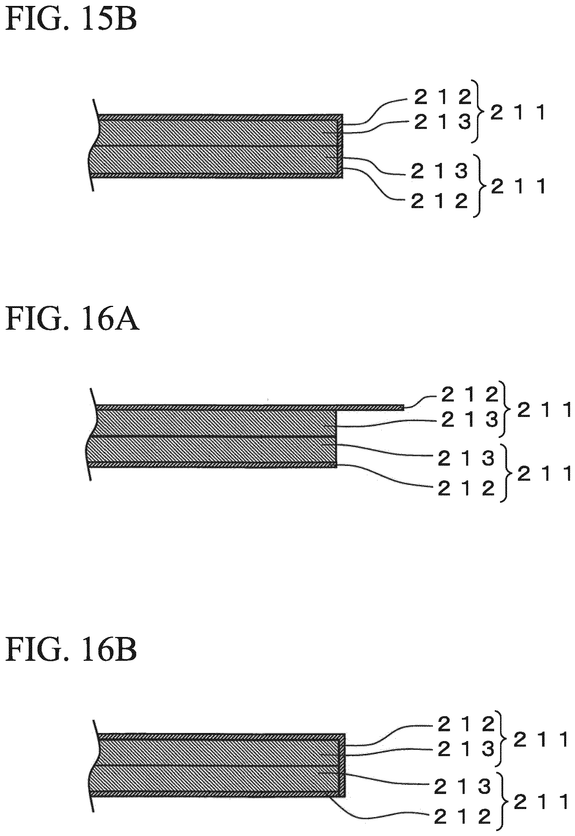

FIGS. 15A and 15B are enlarged explanatory cross-sectional views showing the end of a seal portion of the vacuum insulator according to an eighth embodiment of the invention.

A vacuum insulator according to the eighth embodiment is formed in the substantially same shape and of the same material as that of the vacuum insulator according to the sixth embodiment.

Moreover, the vacuum insulator according to the eighth embodiment is different from the vacuum insulator according to the sixth embodiment in configuration of the end of the seal portion at which the two packaging materials 211 are superimposed and sealed.

In the vacuum insulator according to the eighth embodiment, as shown in FIG. 15A, at the end of the seal portion at which the two packaging materials 211 are superimposed and sealed, the length of each of the base material layers 212 of the packaging materials 211 is longer than the length of the sealant layer 213.

Moreover, the longer base material layer 212 of the packaging material 211 is bent so as to cover the edge surface of the sealant layer 213.

In a state where the seal portion is formed as mentioned above, the front-end portions of the base material layers 212 of the two packaging materials 211 are in butt contact with each other.

In other cases, the base material layers 212 of the front-end portions may overlap each other.

The folded base material layers 212 can be adhesively attached to the sealant layer 213 with an adhesive.

As a result of forming the seal portion in the above-described manner, at the ends of the seal portions which are superimposed and sealed, the base material layers 212 of the two packaging materials 211 are surrounded by the sealant layer 213, and the sealant layers 213 are not exposed to the outside.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

### Ninth Embodiment

Hereinbelow, a ninth embodiment of the invention will be described.

FIGS. 16A and 16B are enlarged explanatory cross-sectional views showing the end of a seal portion of the vacuum insulator according to a ninth embodiment of the invention.

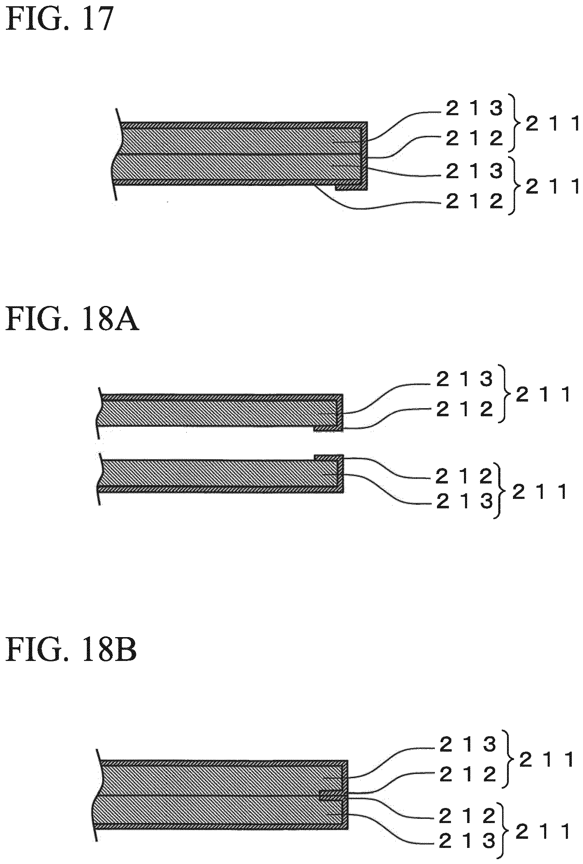

FIG. 17 is an enlarged explanatory cross-sectional view showing a modified example of the configuration the end of the seal portion of the vacuum insulator according to the ninth embodiment of the invention.

A vacuum insulator according to the ninth embodiment is formed in the substantially same shape and of the same material as that of the vacuum insulator according to the sixth embodiment.

Moreover, the vacuum insulator according to the ninth embodiment is different from the vacuum insulator according to the sixth embodiment in configuration of the end of the seal portion at which the two packaging materials 211 are superimposed and sealed.

In the vacuum insulator according to the ninth embodiment, as shown in FIG. 16A, the length of the base material layer 212 forming one of the packaging materials 211 (first packaging material) is longer than the length of the sealant layer 213 of said one of packaging material 211 at the end of the seal portion at which the two packaging materials 211 are superimposed and sealed.

Additionally, the longer base material layer 212 of one of the packaging materials 211 is bent so as to cover the edge surfaces of the sealant layers 213 of the two packaging materials 211.

In a state where the seal portion is formed as mentioned above, one of the packaging materials 211 is provided so that the front-end portion of the longer base material layer 212 of one of the packaging materials 211 reaches the base material layer 212 of the other of the packaging materials 211.

In other cases, as shown in FIG. 17, the front-end portion of the longer base material layer 212 of one of the packaging materials 211 may be further bent and may overlap the outer surface of the other of the base material layers 212 of the packaging materials 211.

The folded base material layer 212 can be adhesively attached to the sealant layer 213 and the other of the base material layers 212 of the packaging materials 211 with an adhesive.

As a result of forming the seal portion in the above-described manner, at the ends of the seal portions which are superimposed and sealed, both sealant layers 213 of the two packaging materials 211 are surrounded by the longer base material layer 212 of one of the packaging materials 211, and the sealant layers 213 are not exposed to the outside.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

### Tenth Embodiment

Hereinbelow, a tenth embodiment of the invention will be described.

FIGS. 18A and 18B are enlarged explanatory cross-sectional views showing the end of a seal portion of the vacuum insulator according to a tenth embodiment of the invention.

A vacuum insulator according to the tenth embodiment is formed in the substantially same shape and of the same material as that of the vacuum insulator according to the sixth embodiment.

Moreover, the vacuum insulator according to the tenth embodiment is different from the vacuum insulator according to the sixth embodiment in configuration of the end of the seal portion at which the two packaging materials 211 are superimposed and sealed.

In the vacuum insulator according to the tenth embodiment, as shown in FIG. 18A, at the end of the seal portion at which the two packaging materials 211 are superimposed and sealed, the lengths of the base material layers 212 of the packaging materials 211 are longer than the length of the sealant layer 213.

Moreover, the front-end portion is folded at each of the two packaging materials 211 so that the front-end portion of the longer base material layer 212 covers the edge surface of the sealant layer 213 and is further located inside the superimposed seal portions.

Furthermore, as shown in FIG. 18B, in a state where the front-end portion of the base material layer 212 of each packaging material 211 is folded back, the two packaging materials 211 are superimposed and sealed.

As a result of forming the seal portion in the above-described manner, at the ends of the seal portions which are superimposed and sealed, the base material layers 212 of the two packaging materials 211 are brought into close contact with each other and are surrounded by the base material layer 212, and the sealant layers 213 are not exposed to the outside.

Accordingly, a gas such as air is prevented from passing from the outside of the exterior body 201 to the inside thereof through the sealant layer 213 having a low degree of gas barrier property, and it is possible to maintain the heat insulation property of the vacuum insulator for a long time.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

### Examples

Hereinbelow, Examples according to the invention will be particularly described; however, the invention is not limited to the Examples.

Firstly, Example A1 corresponding to the above-described first embodiment and Example A1 and the Comparative Examples A1 and A2 which are used to explain Example A1 will be described.

### Example A1

As the base member 12, a biaxially-oriented polyethylene terephthalate (PET) film having a thickness of 12 µm was used.

Aluminum oxide having a thickness of 15 nm was vapor-deposited onto one surface of the biaxially-oriented polyethylene terephthalate film by evaporating metal aluminum by a vacuum deposition apparatus using electron beam heating and introducing an oxygen gas thereinto, and the vapor-deposited thin film layer 13 made of inorganic oxide was formed.

Next, an coating agent having the following composition was applied on the vapor-deposited thin film layer 13 by a gravure coating method, thereafter, was dried for one minute at 120°C, the coating layer 14 having a thickness of 0.5 µm was formed on the vapor-deposited thin film layer 13, and the barrier film 11 was thereby obtained.

The coating agent is obtained by mixing the following "first liquid" and "second liquid" at a mix ratio (wt%) of 60:40.

The "first liquid" is a hydrolyzed solution having a solid content of 3 wt% (in terms of SiO₂) into which hydrochloric acid (0.1N) of 89.6 g is added to tetraethoxysilane of 10.4 g, which is agitated for 30 minutes and thereby hydrolyzed.

The "second liquid" is a compound liquid in which water including polyvinyl alcohol of 3 wt% and isopropyl alcohol are mixed (the weight ratio between water and isopropyl alcohol is 90: 10).

Subsequently, the aluminum-deposited ethylene-vinyl alcohol copolymer film 21 having a thickness of 15 µ was adhesively attached to and stacked on the barrier film 11 by use of urethane-based adhesive.

After that, a linear low density polyethylene film having a thickness of 50 µm was attached to an aluminum-deposited ethylene-vinyl alcohol copolymer film, and the vacuum insulator packaging material of Example A1 was thereby obtained as the heat-fusible layer 31.

The layered structure of the vacuum insulator packaging material of Example A1 is shown in FIG. 6.

### Comparative Example A1

An aluminum-deposited polyethylene terephthalate film having a thickness of 12 µm was used instead of the barrier film 11 used in Example A1, the other layered structure of the Comparative Example A1 was the same as that of Example A1, and the vacuum insulator packaging material of the Comparative Example A1 was thereby obtained.

The layered structure of the vacuum insulator packaging material of the Comparative Example A1 is shown in FIG. 7.

### Comparative Example A2

The barrier film 11 was additionally used instead of the aluminum-deposited ethylene-vinyl alcohol copolymer film 21 used in Example A1, the other layered structure of the Comparative Example A2 was the same as that of Example A1, and the vacuum insulator packaging material of the Comparative Example A2 was thereby obtained.

The layered structure of the vacuum insulator packaging material of the Comparative Example A2 is shown in FIG. 8.

### Evaluation

The evaluation of gas barrier properties of the vacuum insulator packaging materials which are obtained by the aforementioned Example A1 and the Comparative Examples A1 and A2 were carried out.

The evaluation of the gas barrier properties was carried out by measuring a degree of oxygen permeability in compliance with the method according to JIS K7126-2 and by measuring the degree of water vapor permeability at a temperature of 40°C at 90% relative humidity in compliance with JIS K7129.

Furthermore, evaluation (Gelbo test) of the flex resistance of the vacuum insulator packaging materials which are obtained by the aforementioned Example and the Comparative Examples were carried out as mentioned below.

Gelvo type Flex-Cracking Tester provided with a constant-temperature bath (manufactured by TESTER SANGYO CO,. LTD.) was used in the Gelbo test.

The size of test pieces, movement of a movable head, a reciprocation speed, number of twisting, a temperature range, power supply, and the size of device were as follows.
1. The size of test pieces
   Cylindrical shape having 3.5"ϕ × 8" (89 mmϕ × 203 mm).
2. The distance between fixed head and movable head 7" (178 mm).
3. Movement of movable head
   (1) Movement at 3.5" (89.0 mm) while rotating at 440 degrees, and furthermore horizontal movement at 2.5" (63.0 mm)
   (2) Movement at 3.25" (82.6 mm) while rotating at 400 degrees
4. Reciprocation speed
   40 times per minute
5. The number of twisting
   Optionally setting by 4-digit preset counter
6. Temperature range
   -50°C to +200°C
   Digital temperature control: PID control
   Heating system: heating by heater
   Cooling system: use of CO₂ gas
7. Power supply
   AC100V, 50Hz/60Hz
8. The size of device
   Substantially 1100 × 470 × 525 mm

Next, a specific method of Gelbo test will be described.

A test piece having 210 × 297 mm was prepared, the short sides which are located at both sides of the long side (297 mm) were attached to each other, and a cylindrical test piece was obtained.

The both ends of the cylindrical test piece were held by a fixed head and a drive head.

The distance between the fixed head and the drive head became narrower from 7 inches to 3.5 inches while twisting the cylindrical test piece at 440 degrees, and furthermore the distance between the fixed head and the drive head became narrower to be one inches while twisting the cylindrical test piece.

Thereafter, the distance between the fixed head and the drive head became larger to be 3.5 inches, and furthermore the distance between the fixed head and the drive head became larger to be 7 inches while releasing the twist.

The above-described operation of deforming the cylindrical test piece is one reciprocating motion, and the reciprocating motion was carried out 300 times at a rate of 40 times/min under a temperature condition of 25°C.

Furthermore, measurement of a degree of oxygen permeability of the test piece that is subjected to Gelbo test was carried out in compliance with the method according to JIS K7126-2.

Regarding the vacuum insulator packaging materials which are obtained by the aforementioned Example A1 and the Comparative Examples A1 and A2, the results of measuring a degree of oxygen permeability and a degree of water vapor permeability which are before Gelbo test and a degree of oxygen permeability which is after Gelbo test are shown in the following Table 1.

**(Table 1)**

| | EXAMPLE A1 | COMPARATIVE EXAMPLE A1 | COMPARATIVE EXAMPLE A2 |
|---|---|---|---|
| DEGREE OF OXYGEN PERMEABILITY BEFORE GELBO TEST | 0.10 | 0.10 | 0.10 |
| (cc/m²▪day▪atm) | | | |
| DEGREE OF WATER VAPOR PERMEABILITY BEFORE GELBO TEST | 0.01 | 0.10 | 0.01 |
| (g/m²▪day) | | | |
| DEGREE OF OXYGEN PERMEABILITY AFTER GELBO TEST | 0.20 | 0.20 | 1.02 |
| (cc/m²▪day▪ atm) | | | |

As shown in Table 1, the degree of oxygen permeability of Example A1 before Gelbo test is the same as that of the Comparative Examples A1 and A2.

Furthermore, the degree of water vapor permeability of Example A1 before Gelbo test is superior to that of the Comparative Example A1 and is the same as that of the Comparative Example A2.

Moreover, the degree of oxygen permeability of Example A1 after Gelbo test is the same as that of the Comparative Example A1 and is superior to that of the Comparative Example A2.

Comprehensively, the results are obtained that Example A1 is superior to the Comparative Examples A1 and 2A.

Particularly, in consideration of that the Comparative Example A1 uses an aluminum-deposited polyethylene terephthalate film instead of the barrier film 11 and that the Comparative Example A2 additionally uses the barrier film 11 instead of the aluminum-deposited ethylene-vinyl alcohol copolymer film 21, it is apparent that a significant effect is obtained by the configuration including the barrier film 11, the aluminum-deposited ethylene-vinyl alcohol copolymer film 21, and the heat-fusible layer 31 which are stacked in order.

As described above, the vacuum insulator packaging material of Example A1 according to the invention has a high degree of gas barrier property, provides excellent flex resistance, and has a high degree of oxygen barrier property after being bent.

For this reason, the vacuum insulator that uses the vacuum insulator packaging material can maintain a high degree of vacuum state even in the case of being used for a long time..

Furthermore, since a metal foil is not used as a gas barrier layer, a quantity of heat to be transmitted through the gas barrier layer is low, and it is possible to provide a highly-qualified vacuum insulator.

Accordingly, the vacuum insulator packaging material of the invention is applicable to insulating containers, such as a refrigerator-freezer, a freezing device, a hot water dispenser, or a vending machine, various devices, equipments, or the like, which requires cold storage or heat-retention.

As a result, remarkable energy saving can be realized, and it is possible to contribute to space-saving of an insulating container such as a device or a facility.

Next, vacuum insulator packaging materials according to Examples B1 to B3 corresponding to the aforementioned first and third embodiments and vacuum insulator packaging materials according to the Comparative Examples B1 to B4 which are used to explain Examples B1 to B3 will be described.

Each of the layered structures of Examples B1 to B3 and the Comparative Examples B1 to B4 are shown in Tables 2 and 3.

Specifically, Example B1 shows the layered structure corresponding to the first embodiment, and a polyamide film (ONY) or a polypropylene film (OPP) is not provided on the outer surface (exposed surface) of the barrier film 11 (GX12*) in the layered structure.

Example B2 shows the layered structure in which a polyamide film (ONY) is provided on the outer surface (exposed surface) of the barrier film 11 (GX12*).

Example B3 shows the layered structure in which a polypropylene film (OPP) is provided on the outer surface (exposed surface) of the barrier film 11 (GX12*) with a polyamide film (ONY) interposed therebetween.

Additionally, in all cases of Examples B1 to B3, the aluminum-deposited ethylene-vinyl alcohol copolymer film 21 and a linear low density polyethylene film (LL50) that is used as the heat-fusible layer 31 are provided.

Moreover, the Comparative Example B1 is not provided with the barrier film 11 (GX12*) but is provided with an aluminum-deposited polyethylene terephthalate film (VMPET) instead of the barrier film 11.

The Comparative Example B2 provided with two barrier films 11 (GX12*) and a linear low density polyethylene film (LL50).

The Comparative Example B3 shows the layered structure in which a polyamide film (ONY) is provided on the outer surface (exposed surface) of an aluminum-deposited polyethylene terephthalate film (VMPET).

The Comparative Example B4 shows the layered structure in which a polypropylene film (OPP) is provided on the outer surface (exposed surface) of an aluminum-deposited polyethylene terephthalate film (VMPET) with a polyamide film (ONY) interposed therebetween.

Additionally, in all cases of the Comparative Examples B1, B3, and B4, the aluminum-deposited polyethylene terephthalate film (VMPET) and the linear low density polyethylene film (LL50) are provided.

The order of a plurality of layers which are arranged and formed in each of Examples B1 to B3 and the Comparative Examples B1 to B4 is shown in Tables 2 and 3.

Next, the layers which form each of Examples B1 to B3 and the Comparative Examples B1 to B4 will be particularly described.

In Tables 2 and 3, "GX12*" represents the barrier film 11 of the aforementioned embodiment, particularly, shows the structure in which a biaxially-oriented polyethylene terephthalate (PET) film having a thickness of 12 µm is used as a base member, one surface of the base member is subjected to the above-described plasma pretreatment, a vapor-deposited thin film layer is formed on the surface which is subjected to the plasma pretreatment, and the aforementioned coating layer is provided.

The "*VMEVOH15" represents the aluminum-deposited ethylene-vinyl alcohol copolymer film 21 of the aforementioned embodiment and shows that the film thickness is 15 µm.

The "LL50" represents a linear low density polyethylene film which is used as the heat-fusible layer 31 and shows that the film thickness is 50 µm.

The "ONY" represents a polyamide film, the "OPP" represents a polypropylene film, and the "VMPET" represents an aluminum-deposited polyethylene terephthalate film.

Particularly, the "ONY15" represents a polyamide film having a film thickness of 15 µm, the "OPP20" represents a polypropylene film having a film thickness of 20 µm, and the "VMPET12*" represents an aluminum-deposited polyethylene terephthalate film having a film thickness of 12 µm.

Regarding the aforementioned Examples B1 to B3 and the Comparative Examples B1 to B4, the results of measuring a degree of oxygen permeability which is before Gelbo test, the degree of water vapor permeability which is before Gelbo test, a degree of oxygen permeability which is after Gelbo test, a degree of pinking resistance, and the number of pinholes which is after Gelbo test are shown in the following Tables 2 and 3.

Particularly, the Gelbo test which is carried out with respect to the packaging materials of Examples B1 to B3 and the Comparative Examples B1 to B4 is the same as the aforementioned Gelbo test, and the explanations thereof are omitted.

The "pinking resistance" represents the strength of the packaging material which is obtained by a pinking resistance test which will be described below.

In the pinking resistance test, the test was carried out in the case where a needle penetrates through the packaging material in the direction from the top surface of the packaging material to the back surface (from the base member toward the heat-fusible layer) (from front side to back side) and in the case where a needle penetrates through the packaging material in the direction from the back surface of the packaging material to the top surface (from the heat-fusible layer toward the base member) (from back side to front side).

The "the number of Gelbo pinholes" represents the result obtained by determining the number of pinholes by use of penetrant inspection liquid after the Gelbo test is carried out.

**(Table 2)**

| | CONFIGURATION | | | | | DEGREE OF OXYGEN PERMEABILITY BEFORE GELBO TEST | DEGREE OF WATER VAPOR PERMEABILITY BEFORE GELBO TEST | DEGREE OF OXYGEN PERMEABILITY AFTER GELBO TEST |
|---|---|---|---|---|---|---|---|---|
| | | | | | | (cc/m²▪day▪atm) | (g/m²▪day) | (cc/m²▪day▪atm) |
| EXAMPLE B1 1 | | | GX12* | *VMEVOH15 | LL50 | 0.10 | 0.01 | 0.20 |
| EXAMPLE B2(ONY) | | ONY15 | GX12* | *VMEVOH15 | LL50 | 0.10 | 0.01 | 0.20 |
| EXAMPLE B3(OPP+ONY) | OPP2Q | ONY15 | GX12* | *VMEVOH15 | LL5O | 0.10 | 0.01 | 0.20 |
| COMPARATIVE EXAMPLE B1 (VMPET) | | | VMPET12* | *VMEVOH15 | LL50 | 0.10 | 0.10 | 0.20 |
| COMPARATIVE EXAMPLE B2 (GX) | | | GX12* | *GX12 | LL50 | 0.10 | 0.01 | 1.02 |
| COMPARATIVE EXAMPLE B3 (VMPET,ONY) | | ONY15 | VMPET12* | *VMEVOH15 | LL50 | 0.10 | 0.28 | 0.13 |
| COMPARATIVE EXAMPLE B4 (VMPET.OPP+ONY) | OPP2Q | ONY15 | VMPET12* | *VMEVOH15 | LL50 | 0.10 | 0.09 | 0.20 |

**(Table 3)**

| | CONFIGURATION | | | | | PINKING RESISTANCE (N) | | NUMBER OF GELBO PINHOLES |
|---|---|---|---|---|---|---|---|---|
| | | | | | | FROM FRONT SIDE TO BACK SIDE | FROM BACK SIDE TO FRONT SIDE | |
| EXAMPLE B1 | | | GX12* | *VMEVOH15 | LL50 | 15 | 13 | 1.0 |
| EXAMPLE B2(ONY) | | ONY15 | GX12* | *VMEVOH15 | LL50 | 24 | 22 | 0.3 |
| EXAMPLE B3(OPP+ONY) | OPP20 | ONY15 | GX12* | *VMEVOH15 | LL50 | 29 | 22 | 0.0 |
| COMPARATIVE EXAMPLE B1 (VMPET) | | | VMPET12* | *VMEVOH15 | LL50 | 15 | 13 | 1.0 |
| COMPARATIVE EXAMPLE B2 (GX) | | | GX12* | *GX12 | LL50 | 13 | 12 | 1.5 |
| COMPARATIVE EXAMPLE B3 (VMPET,ONY) | | ONY15 | VMPET12* | *VMEVOH15 | LL50 | 24 | 22 | 0.7 |
| COMPARATIVE EXAMPLE B4 (VMPET,OPP+ONY) | OPP20 | ONY15 | VMPET12* | *VMEVOH15 | LL50 | 30 | 27 | 0.0 |

As shown in Tables 2 and 3, according to the degree of oxygen permeability which is before Gelbo test, the degree of water vapor permeability which is before Gelbo test, and the degree of oxygen permeability which is after Gelbo test, the same results are obtained in Examples B1 to B3, the result of the Comparative Example B1 is the same as that of Examples B1 to B3.

In contrast, it is determined that the degree of oxygen permeability of the Comparative Example B2 which is after Gelbo test is higher than that of Examples B1 to B3.

Furthermore, it is determined that the degrees of water vapor permeability of the Comparative Examples B3 and B4 which are before Gelbo test are higher than that of Examples B1 to B3.

Moreover, it is seen that, as compared with Examples B1 and B2, the pinking resistance of Example B3 is higher and the number of Gelbo pinholes is lower.

As described above, the vacuum insulator packaging materials of Examples B1 to B3 according to the invention has a high degree of gas barrier property, provides excellent flex resistance, and has a high degree of oxygen barrier property after being bent.

For this reason, the vacuum insulator that uses the vacuum insulator packaging material can maintain a high degree of vacuum state even in the case of being used for a long time..

Furthermore, since a metal foil is not used as a gas barrier layer, a quantity of heat to be transmitted through the gas barrier layer is low, and it is possible to provide a highly-qualified vacuum insulator.

Accordingly, the vacuum insulator packaging material of the invention is applicable to insulating containers, such as a refrigerator-freezer, a freezing device, a hot water dispenser, or a vending machine, various devices, equipments, or the like, which requires cold storage or heat-retention.

As a result, remarkable energy saving can be realized, and it is possible to contribute to space-saving of an insulating container such as a device or a facility.

Next, the vacuum insulator packaging material of Example C1 corresponding to the aforementioned fifth embodiment and vacuum insulator packaging materials according to the Comparative Examples C1 to C3 which are used to explain Example C1 will be described.

The evaluation of the pinking resistance which is carried out with respect to the vacuum insulator packaging materials of Example C1 and the Comparative Examples C1 to C3 was carried out as mentioned below.

### Pinking Resistance Test

A test piece (packaging material) was fixed, and the packaging material was impaled by a needle which has a diameter of 1.0 mm and has a front-end formed in a semicircular shape at a rate of 50 mm per minute.

After the impaling is started, until the impaling is completed (the needle penetrates the packaging material), the maximum stress was measured during the pinking resistance test.

The number of test pieces is five.

The average value was determined from the five maximum stresses obtained from the five test pieces.

The test was carried out in the case where the impaling is carried out in the direction from the base material layer of the packaging material to the sealant layer and in the case where the impaling is carried out in the direction from the sealant layer of the packaging material to the base material layer, and the maximum stress was measured.

### Example C1

An oriented polypropylene film (base material layer) having a thickness of 20 µm, an oriented nylon film (base material layer) having a thickness of 15 µm, an aluminum-deposited polyethylene terephthalate film (barrier layer) having a thickness of 12 µm, and an aluminum-deposited ethylene-vinyl alcohol copolymer film (barrier layer) having a thickness of 15 µm were stacked in this order and are adhesively attached by use of a urethane-based adhesive.

Next, a linear low density polyethylene film which serves as a sealant layer and has a thickness of 50 µm and the density of 0.923 g/cm³ is adhesively attached to the surface of the aluminum-deposited ethylene-vinyl alcohol copolymer film of the aforementioned layered body, the vacuum insulator packaging material formed of the base material layer, the barrier layer, and the sealant layer was obtained.

### Comparative Example C1

An oriented polypropylene film is not used in the base material layer of the Comparative Example C1, the packaging material of the Comparative Example C1 was manufactured so that the layers other than the base material layer are the same as that of Example C1.

### Comparative Example C2

An aluminum foil having a thickness of 7 µm is used instead of the aluminum-deposited ethylene-vinyl alcohol copolymer film of the Comparative Example C1, the packaging material of the Comparative Example C2 was manufactured so that the layers other than the aluminum foil are the same as that of the Comparative Example C1.

### Comparative Example C3

A linear low density polyethylene film having the density of 0.94 g/cm³ is used instead of the linear low density polyethylene film of the Comparative Example C2 which has the density of 0.923 g/cm³, the packaging material of the Comparative Example C3 was manufactured so that the layers other than this film are the same as that of the Comparative Example C2.

### Evaluation

The pinking resistances of the vacuum insulator packaging materials obtained by the aforementioned Example C1 and the Comparative Examples C1 to C3 were evaluated.

Particularly, the strength in the case of impaling the packaging material in the direction from the base material layer to the sealant layer is represented as "FROM FRONT SIDE TO BACK SIDE", and the strength in the case of impaling the packaging material in the direction from the sealant layer to the base material layer is represented as "FROM BACK SIDE TO FRONT SIDE".

The above-mentioned evaluation results are shown in Table 4.

**(Table 4)**

| | | EXAMPLE C1 | COMPARATIVE EXAMPLE C1 | COMPARATIVE EXAMPLE C2 | COMPARATIVE EXAMPLE C3 |
|---|---|---|---|---|---|
| PINKING RESISTANCE | FROM FRONT SIDE TO BACK SIDE | **29.8** | **23.6** | **15.9** | **17.1** |
| (**N**) | FROM BACK SIDE TO FRONT SIDE | **26.5** | **22.0** | **14.7** | **16.8** |

As shown in Table 4, the pinking resistance of the vacuum insulator packaging material of Example C1 according to the invention is superior to the vacuum insulator packaging materials according to the Comparative Examples C1 to C3.

This shows the effects that are obtained due to the oriented polypropylene film which is arranged at the uppermost layer of the packaging material.

As described above, Example C1 according to the invention can provide a vacuum insulator packaging material having a high degree of pinking resistance.

Additionally, as a result of using the vacuum insulator using the packaging material according to the invention, it is possible to provide an insulating container in which pinholes due to impact caused by vibration or the like are less likely to occur.

### DESCRIPTION OF REFERENCE NUMERAL

- 1...: vacuum insulator
- 2, 211...: packaging material
- 3...: core (core member)
- 4...: seal portion
- 11...: barrier film
- 12, 15...: base member (plastic base member)
- 13...: vapor-deposited thin film layer
- 14...: coating layer
- 16...: vapor-deposited thin film layer
- 17...: coating layer
- 21...: aluminum-deposited ethylene-vinyl alcohol copolymer film
- 22...: aluminum vapor-deposited layer
- 23...: ethylene-vinyl alcohol copolymer film
- 31...: heat-fusible layer
- 41...: plasma gas introducer
- 42...: shield plate
- 43...: electrode
- 44...: impedance matching box
- 46...: cooling drum
- 50...: processing chamber
- 110...: oriented polypropylene film
- 111...: oriented nylon film
- 112...: aluminum-deposited polyethylene terephthalate film
- 113...: aluminum-deposited ethylene-vinyl alcohol copolymer film
- 115...: adhesive layer
- 116...: outer side
- 201...: exterior body
- 212...: base material layer
- 213...: sealant layer
- 202...: core member

## Claims

1. A packaging material for a vacuum insulator, comprising:
a barrier film comprising a plastic base member;
an aluminum-deposited ethylene-vinyl alcohol copolymer film stacked on the barrier film; and
a heat-fusible layer stacked on the aluminum-deposited ethylene-vinyl alcohol copolymer film, wherein
a vapor-deposited thin film layer and a coating layer are sequentially stacked in layers in order on at least one surface of the plastic base member of the barrier film, wherein
the vapor-deposited thin film layer is formed of a composite comprising: a metal or an inorganic oxide, or a metal and an inorganic oxide, wherein
the coating layer is made of an aqueous solution or a coating agent, wherein
the aqueous solution comprises: a water-soluble polymer; and at least one of (a) and (b), (a) being at least one of, one or more kinds of alkoxide, and one or more kinds of hydrolyzate of alkoxide, (b) being tin chlorides, wherein
the coating agent comprises as a main agent a mixed solution of water and alcohol, and wherein
a surface of the plastic base member opposite to the surface of the plastic base member on which the vapor-deposited thin film layer is formed, is an uppermost layer of the packaging material,
the aluminum-deposited ethylene-vinyl alcohol copolymer film includes an aluminum vapor-deposited layer, and
the aluminum vapor-deposited layer is adhesively attached to the coating layer.

2. The packaging material for a vacuum insulator according to claim 1, wherein
the heat-fusible layer is a linear low density polyethylene film.

3. The packaging material for a vacuum insulator according to claim 1 or claim 2, wherein
the plastic base member is subjected to a plasma pretreatment by specific plasma using a hollow-anode plasma processing apparatus before the vapor-deposited thin film layer is vapor-deposited onto the plastic base member.

4. The packaging material for a vacuum insulator according to claim 3, wherein
the hollow-anode plasma processing apparatus is a magnetic-assisted hollow-anode plasma processing apparatus further including a magnet.

5. The packaging material for a vacuum insulator according to claim 3 or claim 4, wherein
the plasma pretreatment uses at least one selected from the group consisting of argon, nitrogen, oxygen, and hydrogen and uses low-temperature plasma in which a self-bias value is 200V to 2000V and an Ed value defined by Ed=plasma density × processing time is 100 (V·s·m⁻²) to 10000 (V·s·m⁻²).

6. The packaging material for a vacuum insulator according to any one of claims 3 to 5, wherein
the plasma pretreatment includes: a first treatment step that is carried out using an inert gas; and a second treatment step that is subsequently carried out using at least one selected from the group consisting of nitrogen, oxygen, hydrogen, and a mixed gas thereof.

7. The packaging material for a vacuum insulator according to claim 6, wherein
the inert gas is at least one of argon and helium.

8. The packaging material for a vacuum insulator according to claim 3 or claim 4, wherein
the plasma pretreatment includes: a first treatment step that is carried out using a mixed gas of nitrogen and oxygen; and a second treatment step that is subsequently carried out using hydrogen.

9. The packaging material for a vacuum insulator according to claim 1, further comprising:
a nylon film provided between the barrier film and the aluminum-deposited ethylene-vinyl alcohol copolymer film.

10. The packaging material for a vacuum insulator according to claim 1, further comprising:
an oriented polypropylene film provided on the uppermost layer.

11. A vacuum insulator using the packaging material according to any one of claims 1 to 10.

12. An insulating container using the vacuum insulator according to claim 11.

## Patentansprüche

1. Packmaterial für einen Vakuumisolator, umfassend:
einen Barrierefilm, der ein Kunststoffgrundelement umfasst;
einen auf den Barrierefilm geschichteten Aluminium-abgeschiedenen Ethylen-Vinylalkohol-Copolymerfilm; und
eine auf den Aluminium-abgeschiedenen Ethylen-Vinylalkohol-Copolymerfilm geschichtete wärmeschmelzbare Schicht, wobei
eine aufgedampfte Dünnfilmschicht und eine Überzugsschicht nacheinander der Reihe nach auf zumindest einer Oberfläche des Kunststoffgrundelements des Barrierefilms geschichtet sind, wobei
die aufgedampfte Dünnfilmschicht aus einem Komposit gebildet ist, das umfasst: ein Metall oder ein anorganisches Oxid, oder ein Metall und ein anorganisches Oxid, wobei
die Überzugsschicht aus einer wässrigen Lösung oder einem Beschichtungsmittel hergestellt ist, wobei
die wässrige Lösung umfasst: ein wasserlösliches Polymer; und zumindest eines aus (a) und (b), wobei (a) zumindest eines oder mehrere Arten von Alkoxid und eines oder mehrere Arten von Hydrolisat von Alkoxid ist, und (b) Zinnchloride sind, wobei
das Beschichtungsmittel als ein Hauptmittel eine gemischte Lösung aus Wasser und Alkohol umfasst, und wobei
eine Oberfläche des Kunststoffgrundelements, die der Oberfläche des Kunststoffgrundelements entgegensteht, auf welcher die aufgedampfte Dünnfilmschicht geschichtet ist, eine oberste Schicht des Packmaterials ist,
der Aluminium-abgeschiedenen Ethylen-Vinylalkohol-Copolymerfilm eine Aluminium-aufgedampfte Schicht beinhaltet, und
die Aluminium-aufgedampfte Schicht an die Überzugsschicht haftend angebracht ist.

2. Packmaterial für einen Vakuumisolator nach Anspruch 1, wobei
die wärmeschmelzbare Schicht ein Linear-Niederdichte-Polyethylenfilm ist.

3. Packmaterial für einen Vakuumisolator nach Anspruch 1 oder 2, wobei
das Kunststoffgrundelement einer Plasmavorbehandlung mit spezifischem Plasma unter Verwendung eines Hohlanodenplasmaprozessierapparats vorbehandelt ist, bevor die aufgedampfte Dünnfilmschicht auf das Kunststoffgrundelement aufgedampft wird.

4. Packmaterial für einen Vakuumisolator nach Anspruch 3, wobei
der Hohlanodenplasmaprozessierapparat ein magnetfeldunterstützter Hohlanodenplasmaprozessierapparat ist, der ferner einen Magneten beinhaltet.

5. Packmaterial für einen Vakuumisolator nach Anspruch 3 oder 4, wobei
die Plasmabehandlung zumindest eines verwendet ausgewählt aus der Gruppe bestehend aus Argon, Stickstoff, Sauerstoff und Wasserstoff, und ein Niedertemperaturplasma verwendet, bei welchem ein Eigengrundspannungs-(bzw. self-bias)-wert 200V bis 2000V beträgt und ein Ed-Wert, der durch Ed = Plasmadichte × Prozessierungszeit definiert ist, 100 (V·s·m⁻²) bis 10000 (V·s·m⁻²) beträgt.

6. Packmaterial für einen Vakuumisolator nach einem der Ansprüche 3 bis 5, wobei
die Plasmavorbehandlung beinhaltet: einen ersten Behandlungsschritt, der unter Verwendung eines Inertgases ausgeführt wird; einen zweiten Behandlungsschritt, der nachfolgend unter Verwendung zumindest eines ausgewählt aus der Gruppe bestehend aus Stickstoff, Sauerstoff, Wasserstoff und einem gemischten Gas daraus ausgeführt wird.

7. Packmaterial für einen Vakuumisolator nach Anspruch 6, wobei das Inertgas zumindest eines aus Argon und Helium ist.

8. Packmaterial für einen Vakuumisolator nach Anspruch 3 oder 4, wobei
die Plasmavorbehandlung beinhaltet: einen ersten Behandlungsschritt, der unter Verwendung eines gemischten Gases aus Stickstoff und Sauerstoff ausgeführt wird; und einen zweiten Behandlungsschritt, der nachfolgend unter Verwendung von Wasserstoff ausgeführt wird.

9. Packmaterial für einen Vakuumisolator nach Anspruch 1, das ferner umfasst:
einen Nylonfilm, der zwischen dem Barrierefilm und dem Aluminium-abgeschiedenen Ethylen-Vinylalkohol-Copolymerfilm vorgesehen ist.

10. Packmaterial für einen Vakuumisolator nach Anspruch 1, das ferner umfasst:
einen orientierten Polypropylenfilm, der auf der obersten Schicht vorgesehen ist.

11. Vakuumisolator, der das Packmaterial nach einem der Ansprüche 1 bis 10 einsetzt.

12. Isolierender Behälter, der den Vakuumisolator nach Anspruch 11 einsetzt.

## Revendications

1. Matériau d'emballage pour un isolant sous vide, comprenant :
un film de barrière comprenant un élément de base en matière plastique ;
un film en copolymère d'éthylène-alcool vinylique déposé sur de l'aluminium empilé sur le film de barrière ; et
une couche thermofusible empilée sur le film en copolymère d'éthylène-alcool vinylique déposé sur de l'aluminium,
dans lequel une couche en film mince déposée en phase vapeur et une couche de revêtement sont empilées successivement en couches dans l'ordre sur au moins une surface de l'élément de base en matière plastique du film de barrière,
dans lequel la couche en film mince déposée en phase vapeur est formée d'un composite comprenant : un métal ou un oxyde inorganique, ou un métal et un oxyde inorganique,
dans lequel la couche de revêtement est faite d'une solution aqueuse ou d'un agent de revêtement,
dans lequel la solution aqueuse comprend : un polymère soluble dans l'eau ; et au moins l'un de (a) et (b), (a) étant au moins l'un parmi un ou plusieurs types d'alkylates, et un ou plusieurs types d'hydrolysats d'alkylates, (b) étant constitué de chlorures d'étain,
dans lequel l'agent de revêtement comprend, en tant qu'agent principal, une solution mixte d'eau et d'alcool,
et dans lequel la surface de l'élément de base en matière plastique opposée à la surface de l'élément de base en matière plastique sur laquelle est formée la couche en film mince déposée en phase vapeur est la couche la plus supérieure du matériau d'emballage,
le film en copolymère d'éthylène-alcool vinylique déposé sur de l'aluminium comprend une couche déposée en phase vapeur sur de l'aluminium, et
la couche déposée en phase vapeur sur de l'aluminium est attachée par adhésion à la couche de revêtement.

2. Matériau d'emballage pour un isolant sous vide selon la revendication 1, dans lequel la couche thermofusible est un film de polyéthylène basse densité linéaire.

3. Matériau d'emballage pour un isolant sous vide selon la revendication 1 ou la revendication 2, dans lequel l'élément de base en matière plastique est soumis à un prétraitement au plasma au moyen d'un plasma spécifique utilisant un dispositif de traitement par plasma à anode creuse avant que la couche en film mince déposée en phase vapeur soit déposée en phase vapeur sur l'élément de base en matière plastique.

4. Matériau d'emballage pour un isolant sous vide selon la revendication 3, dans lequel le dispositif de traitement par plasma à anode creuse est un dispositif de traitement par plasma à anode creuse à assistance magnétique comprenant en outre un aimant.

5. Matériau d'emballage pour un isolant sous vide selon la revendication 3 ou 4, dans lequel le prétraitement au plasma utilise au moins l'un choisi dans le groupe constitué par l'argon, l'azote, l'oxygène et l'hydrogène et utilise un plasma à basse température dans lequel la valeur de polarisation automatique est de 200 V à 2 000 V et la valeur Ed définie par Ed = densité de plasma x temps de traitement est de 100 (V•s•m⁻²) à 1 000 (V•s•m²).

6. Matériau d'emballage pour un isolant sous vide selon l'une quelconque des revendications 3 à 5, dans lequel le prétraitement au plasma comprend : une première étape de traitement qui est effectuée en utilisant un gaz inerte ; et une deuxième étape de traitement qui est effectuée ensuite en utilisant au moins l'un choisi dans le groupe constitué par l'azote, l'oxygène, l'hydrogène, et un mélange gazeux de ceux-ci.

7. Matériau d'emballage pour un isolant sous vide selon la revendication 6, dans lequel le gaz inerte est au moins l'un parmi l'argon et l'hélium.

8. Matériau d'emballage pour un isolant sous vide selon la revendication 3 ou la revendication 4, dans lequel le prétraitement au plasma comprend : une première étape de traitement qui est effectuée en utilisant un mélange gazeux d'azote et d'oxygène ; et une deuxième étape de traitement qui est effectuée ensuite en utilisant de l'hydrogène.

9. Matériau d'emballage pour un isolant sous vide selon la revendication 1, comprenant en outre un film en nylon disposé entre le film de barrière et le film en copolymère d'éthylène-alcool vinylique déposé sur de l'aluminium.

10. Matériau d'emballage pour un isolant sous vide selon la revendication 1, comprenant en outre un film en polypropylène orienté disposé sur la couche la plus extérieur.

11. Isolant sous vide utilisant le matériau d'emballage selon l'une quelconque des revendications 1 à 10.

12. Récipient isolant utilisant l'isolant sous vide selon la revendication 11.
